# EUROPEAN PATENT APPLICATION

(11) **EP 2 400 542 A1**
(43) Date of publication of application: **28.12.2011**
(21) Application number: 10743718.8
(22) Date of filing: 15.02.2010
(51) Int. Cl.: H01L 23/10, H01L 23/02, H01L 27/14

(54) **METHOD FOR PRODUCING SEMICONDUCTOR WAFER ASSEMBLY, SEMICONDUCTOR WAFER ASSEMBLY, AND SEMICONDUCTOR DEVICE**

(30) Priority: 23.02.2009 JP 2009039843
(71) Applicant: Sumitomo Bakelite Company Limited, Shinagawa-ku Tokyo 140-0002 (JP)
(72) Inventor: SATO Toshihiro, Tokyo 140-0002 (JP); KAWATA Masakazu, Tokyo 140-0002 (JP); YONEYAMA Masahiro, Tokyo 140-0002 (JP); TAKAHASHI Toyosei, Tokyo 140-0002 (JP); DEJIMA Hirohisa, Tokyo 140-0002 (JP); SHIRAISHI Fumihiro, Tokyo 140-0002 (JP)
(74) Representative: Solf, Alexander
(86) International application number: PCT/JP2010/052193
(87) International publication number: WO 2010/095592

(57) **Abstract**

A method of manufacturing a semiconductor wafer bonding product according to the present invention, including: a step of preparing a spacer formation film including a support base and a spacer formation layer; a step of attaching the spacer formation layer of the spacer formation film to a semiconductor wafer; a step of selectively exposing the spacer formation layer with an exposure light via a mask, which is placed at a side of the support base of the spacer formation film, so as to be passed through the support base; a step of removing the support base; a step of developing the spacer formation layer to form a spacer on the semiconductor wafer; and a step of bonding a transparent substrate to a surface of the spacer opposite to the semiconductor wafer.

## Description

### TECHNICAL FIELD

The present invention relates to a method of manufacturing a semiconductor wafer bonding product, a semiconductor wafer bonding product and a semiconductor device.

### RELATED ART

Semiconductor devices represented by a CMOS sensor, a CCD sensor and the like arc known. In general, such a semiconductor device includes a semiconductor substrate provided with a light receiving portion, a spacer provided on the semiconductor substrate and formed so as to surround the light receiving portion, and a transparent substrate bonded to the semiconductor substrate via the spacer.

Such a semiconductor device is generally manufactured using a manufacturing method including: a step of attaching a bonding film (spacer formation layer) having an electron beam curable property to a semiconductor wafer on which a plurality of light receiving portions are provided; a step of selectively irradiating the bonding film with an electron beam via a mask to expose the bonding film; a step of developing the exposed bonding film to form the spacer; a step of bonding a transparent substrate to the thus formed spacer to obtain a semiconductor product (hereinbelow, it will be referred to as "semiconductor wafer bonding product"); and a step of dicing the semiconductor product to obtain semiconductor devices (see, for example, Patent Document 1).

However, according to the conventional method, since a bonding surface of the bonding film is kept exposed during the exposing step, it is easy to allow foreign substances such as dust to adhere to the surface of the bonding film. When such foreign substances have once adhered to the surface of the bonding film, it is difficult to remove therefrom. As a result, the foreign substances which have adhered prevent the exposure of the bonding film, which makes it difficult to form the spacer at sufficient dimensional accuracy.

Further, there is another problem in that the mask adheres to The bonding film during the exposing step. In order to prevent such adhesion of the mask to the bonding film, it may be conceived to make a distance between the bonding film and the mask longer. However, in the case where the distance between the bonding film and the mask is made longer, an image formed from an exposure light with which the bonding film is irradiated is likely to be dim. In such a case, a partition between an exposed region and a non-exposed region becomes unclear or unstable, which also makes it difficult to form the spacer at sufficient dimensional accuracy.

The Patent Document 1 is Japanese Patent Application Laid-open No. 2008-91399.

### SUMMARY OF THE INVENTION

It is an object of the present invention to provide a method of manufacturing a semiconductor wafer bonding product, the method being capable of preventing adhesion of a mask or adhesion of foreign substances to a surface of a spacer formation layer when being exposed and capable of manufacturing a semiconductor wafer bonding product provided with a spacer having excellent dimensional accuracy, and to provide a semiconductor wafer bonding product and semiconductor device each superior reliability.

In order to achieve such an object, the present invention includes the following features (1) to (14).
(1) A method of manufacturing a semiconductor wafer, bonding product including a semiconductor wafer, a transparent substrate provided at a side of a functional surface of the semiconductor wafer and a spacer provided between the semiconductor wafer and the transparent substrate, the method comprising:
   a step of preparing a spacer formation film, the spacer formation film including a support base having a sheet-like shape and a spacer formation layer provided on the support base and having a bonding property;
   a step of attaching the spacer formation layer of the spacer formation film to the functional surface of the semiconductor wafer;
   a step of selectively exposing a region of the spacer formation layer to be formed into the spacer with an exposure light via a mask, which is placed at a side of the support base of the spacer formation film, so as to be passed through the support base;
   a step of removing the support base after the exposure;
   a step of developing the exposed spacer formation layer to form the spacer on the semiconductor wafer; and
   a step of bonding the transparent substrate to a surface of the spacer opposite to the semiconductor wafer.

(2) A method of manufacturing a semiconductor wafer bonding product including a semiconductor wafer, a transparent substrate provided at a side of a functional surface of the semiconductor wafer and a spacer provided between the semiconductor wafer and the transparent substrate, the method comprising:
a step of preparing a spacer formation film, the spacer formation film including a support base having a sheet-like shape and a spacer formation layer provided on the support base and having a bonding property;
a step of attaching the spacer formation layer of the spacer formation film to the transparent substrate;
a step of selectively exposing a region of the spacer formation layer to be formed into the spacer with an exposure light via a mask, which is placed at a side of the support base of the spacer formation film, so as to be passed through the support base;
a step of removing the support base after the exposure;
a step of developing the exposed spacer formation layer to form the spacer on the transparent substrate; and
a step of bonding the functional surface of the semiconductor wafer to a surface of the spacer opposite to the transparent substrate.

(3) The method according to the above feature (1), wherein in the step of exposing, when the mask is placed so as to face the support base, positioning of the mask is carried out by aligning alignment marks provided on the semiconductor wafer with alignment marks provided on the mask.

(4) The method according to the above feature (2), wherein in the step of exposing, when the mask is placed so as to face the support base, positioning of the mask is carried out by aligning alignment marks provided on the transparent substrate with alignment marks provided on the mask.

(5) The method according to the above feature (1) or (2), wherein visible light transmission through the transparent substrate is in the range of 30 to 100%.

(6) The method according to the above feature (1) or (2), wherein visible light transmission through the spacer formation layer is in the range of 30 to 100%.

(7) The method according to the above feature (1) or (2), wherein in the step of exposing, exposure light transmission through the support base is in the range of 50 to 100%.

(8) The method according to the above feature (1) or (2), wherein an average thickness of the support base is in the range of 15 to 50 µm.

(9) The method according to the above feature (1) or (2), wherein in the step of exposing, a distance between the mask and the support base is in the range of 0 to 1,000 µm.

(10) The method according to the above feature (1) or (2), wherein the spacer formation layer is formed of a material containing an alkali soluble resin, a thermosetting resin and a photo polymerization initiator.

(11) The method according to the above feature (10), wherein the alkali soluble resin is a (meth)acryl-modified phenol resin.

(12) The method according to the above feature (10), wherein the thermosetting resin is an epoxy resin.

(13) A semiconductor wafer bonding product manufactured using the method according to the above feature (1) or (2).

(14) A semiconductor device obtained by dicing the semiconductor wafer bonding product according to the above feature (13) along a portion corresponding to the spacer to obtain a plurality of chips of semiconductor devices.

### BRIEF DESCRIPTION OF THE DRAWINGS

FIG. 1 is a sectional view showing one example of a semiconductor device according to the present invention.
FIG. 2 is a longitudinal sectional view showing one example of a semiconductor wafer bonding product according to the present invention.
FIG. 3 is a top view showing one example of the semiconductor wafer bonding product according to the present invention.
FIG. 4 is a process chart showing one example of a method of manufacturing the semiconductor device (semiconductor wafer bonding product) according to the present invention.
FIG. 5 is a process chart showing one example of the method of manufacturing the semiconductor device (semiconductor wafer bonding product) according to the present invention.

### BEST MODE FOR CARRYING OUT THE INVENTION

Hereinafter, description will be made on the present invention in detail.

### <Semicondactor device (image sensor)>

First, description will be made on a semiconductor device manufactured using a semiconductor wafer bonding product according to the present invention prior to description of a method of manufacturing the semiconductor wafer bonding product according to the present invention.

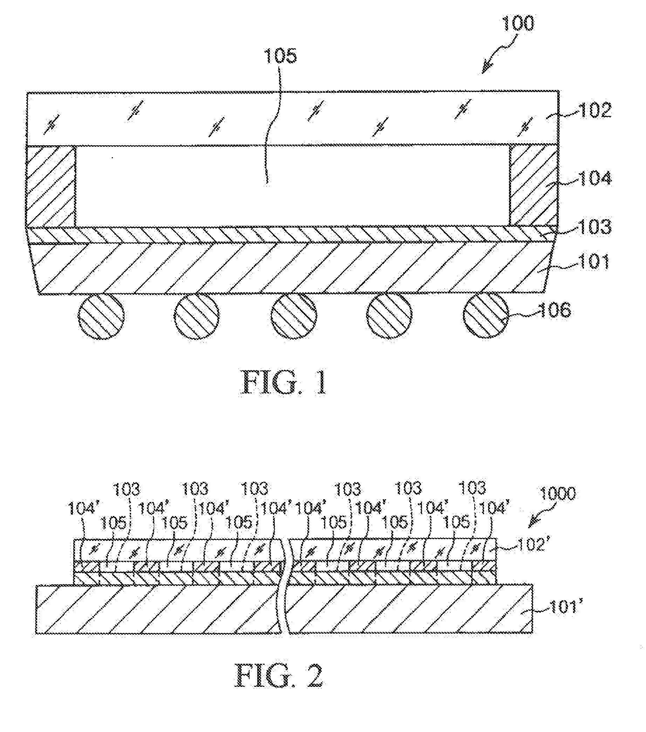

FIG. 1 is a sectional view showing one example of the semiconductor device according to the present invention. In this regard, in the following description, the upper side in FIG. 1 will be referred to as "upper" and the lower side thereof will be referred to as "lower".

As shown in FIG. 1, a semiconductor device (light receiving device) 100 includes a base substrate 101, a transparent substrate 102 provided so as to face the base substrate 101, a light receiving portion 103 formed on the base substrate 101, a spacer 104 formed on an edge of the light receiving portion 103, and solder bumps 106 each formed on a lower surface of the base substrate 101,

The base substrate 101 is a semiconductor substrate. On the semiconductor substrate, provided is a circuit (individual circuit formed on a semiconductor wafer described below) which is not shown in the drawing.

On almost a whole surface of the base substrate 101, the light receiving portion 103 is provided. For example, the light receiving portion 103 has a structure in which a light receiving element and a microlens array are laminated (stacked) in this order from a side of the base substrate 101.

The transparent substrate 102 is provided so as to face the base substrate 101 and has a planar size substantially equal to a planar size of the base substrate 101. For example, the transparent substrate 102 is formed from an acryl resin substrate, a polyethylene terephthalate resin (PET) substrate, a glass substrate or the like.

The spacer 104 directly bonds the microlens array of the light receiving portion 103 to the transparent substrate 102 along an edge thereof, to thereby bond the base substrate 101 to the transparent substrate 102. And, this spacer 104 forms (defines) an air-gap portion 105 between the light receiving portion 103 (microlens array) and the transparent substrate 102.

Since this spacer 104 is provided on the edge of the light receiving portion 103 so as to surround a central area of the light receiving portion 103, an area of the light receiving portion 103 surrounded by the spacer 104 can substantially function as a light receiving portion.

In this regard, it is to be noted that examples of the light receiving element of the light receiving portion 103 include CCD (Charge Coupled Device), CMOS (Complementary Metal Oxide Semiconductor) and the like. Such a light receiving element changes light received by the light receiving portion 103 to electrical signals.

The solder bumps 106 have conductivity and are electrically connected to a circuit provided on the lower surface of the base substrate 101. This makes it possible for the electrical signals changed from the light in the light receiving portion 103 to be transmitted to the solder bumps 106.

### <Semiconductor wafer bonding product>

Next, description will be made on a semiconductor wafer bonding product.

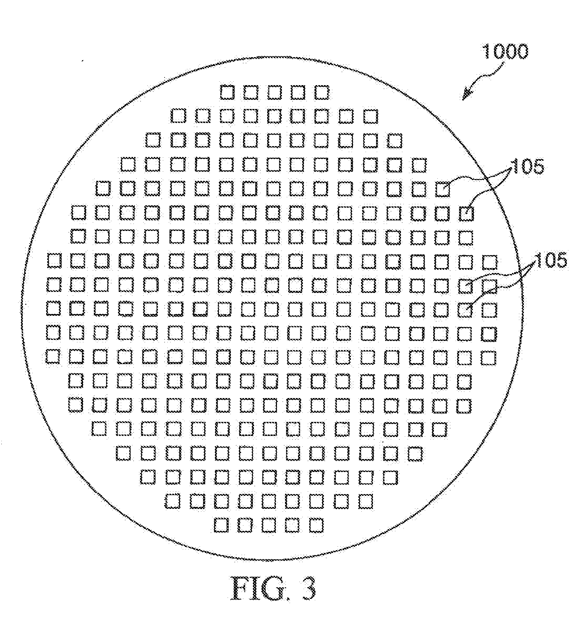

FIG. 2 is a longitudinal sectional view showing one example of the semiconductor wafer bonding product according to the present invention, and FIG. 3 is a top view showing one example of the semiconductor wafer bonding product according to the present invention.

As shown in FIG. 2, a semiconductor wafer bonding product 1000 is formed from a laminated body (stacked body) in which a semiconductor wafer 101', a spacer 104' and a transparent substrate 102' are laminated (stacked) in this order.

The semiconductor wafer 101' becomes the base substrate 101 of the semiconductor device 100 described above through a dicing step described below.

Further, on a functional surface of the semiconductor wafer 101', a plurality of individual circuits (not shown in the drawings) are provided.

Furthermore, on the functional surface of the semiconductor wafer 101', the light receiving portion 103 is formed corresponding to each of the individual circuits,

As shown in FIG. 3, the spacer 104' has a grid-like shape and is provided so as to surround each of the individual circuits (light receiving portions 103) formed on the semiconductor wafer 101'. Further, the spacer 104' forms (defines) a plurality of air-gap portions 105 between the semiconductor wafer 101' and the transparent substrate 102'. Namely, regions each surrounding by the spacer 104' become the air-gap portions 105.

This spacer 104' is a member which becomes the spacer 104 of the semiconductor device 100 as described above through the dicing step as described below.

The transparent substrate 102' is bonded to the semiconductor substrate 101' via the spacer 104'.

This transparent substrate 102' is a member which becomes the transparent substrate 102 of the semiconductor device 100 as described above through the dicing step as described below.

Such a semiconductor wafer bonding product 1000 is diced as described below so that a plurality of the semiconductor devices 100 can be obtained.

<Method of manufacturing semiconductor device (semiconductor wafer bonding product)>
Next, description will be made on a preferred embodiment of the method of manufacturing a semiconductor device (semiconductor wafer bonding produce) according to the present invention.

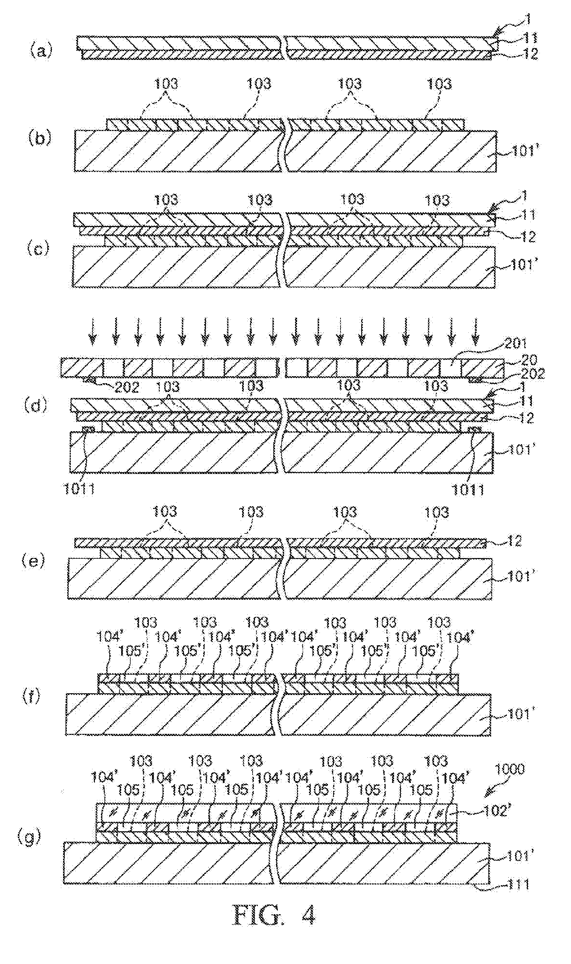

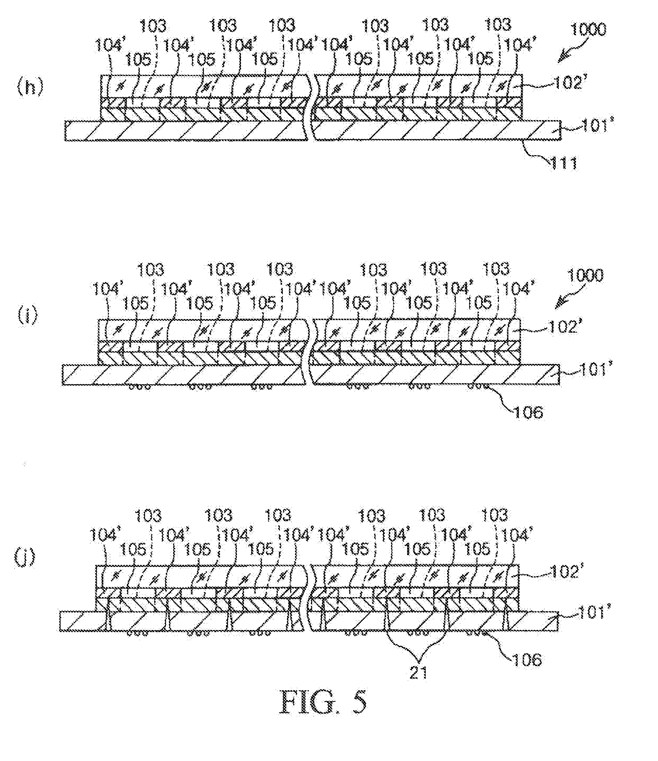

FIGs. 4 and 5 are process charts each showing the preferred embodiment of the method of manufacturing the semiconductor device (semiconductor wafer bonding product) according to the present invention.

First, a spacer formation film 1 is prepared.
As shown in FIG. 4(a), the spacer formation film 1 includes a support base 11 and a spacer formation layer 12 provided on the support base 11.

The support base 11 is a base (member) having a sheet-like shape and has a function for supporting the spacer formation layer 12.

This support base 11 is formed of a material having optical transparency. By forming the support base 11 using such a material having optical transparency, exposure of the spacer formation layer 12 can be carried out while attaching the support base 11 to the spacer formation layer 12 in manufacturing the semiconductor device as described below.

Visible light transmission through the support base 11 is preferably in the range of 30 to 100%, and more preferably in the range of 50 to 100%. This makes it possible to more reliably expose the spacer formation layer 12 during an exposing step described below. Further, this also makes it possible to more reliably carry out positioning between alignment marks of a mask and alignment marks of the semiconductor wafer 101' (transparent substrate 102') as described below.

Further, exposure light (i-beam having 365 nm) transmission through the support base 11 is preferably in the range of 50 to 100%,nd more preferably in the range of 65 to 100%. This makes it possible to more reliably expose the spacer formation layer 12.

For example, examples of a material constituting such a support base 11 include polyethylene terephthalate (PET), polypropylene (PP), polyethylene (PE) and the like. Among them, it is preferable to use the polyethylene terephthalate (PET) from the viewpoint of having optical transparency and rupture strength in excellent balance.

The spacer formation layer 12 has a bonding property with respect to a surface of the semiconductor wafer and is a layer to be bonded to the semiconductor wafer. A resin composition constituting the spacer formation layer 12 will be described below in detail.

Visible light transmission through the spacer formation layer 12 is preferably in the range of 30 to 100, and more preferably in the range of 50 to 100%. This makes it possible to more reliably expose the spacer formation layer 12 along a thickness direction thereof during the exposure step described below. Further, this also makes it possible to more reliably carry out the positioning between the alignment marks of the mask and the alignment marks of the semiconductor wafer 101' (transparent substrate 102') as described below.

Here, the visible light transmission through the support base 11 and spacer formation layer 12 can be measured using the following method,

The visible light transmission is measured using a light having a measuring wavelength of 600 nm by a transmission measuring device ("UV-160A" produced by Shimadzu Corporation). In this regard, in the case of the support base, utilized is a support base to be actually used as a measuring sample, whereas in the case of the spacer formation layer, utilized is a spacer formation layer having a thickness of 50 µm as the measuring sample.

On the other hand, prepared is a semiconductor wafer 101' having a plurality of light receiving portions 103 and maicrolens arrays (not shown in the drawings) formed on a functional surface thereof (see FIG. 4(b)).

Next, as shown in FIG. 4(c), the spacer formation layer 12 (bonding surface) of the spacer formation film 1 is attached to the functional surface of the semiconductor wafer 101' (this step is referred to as a laminating step). In this way, it is possible to obtain the semiconductor wafer 101' to which the spacer formation film 1 is attached.

Next, the spacer formation layer 12 is irradiated with a light (ultraviolet ray) to expose it (this step is referred to as an exposing step).
At this time, as shown in FIG. 4(d), used is a mask 20 having a light passing portion 201 at a position corresponding to a portion to be formed into the spacer 104. The light passing portion 201 is a portion through which the light is passed, and the spacer formation layer 12 is irradiated with the light passed through the light passing portion 201.
Therefore, a region of the spacer formation layer 12, which is irradiated with the passed light, is selectively exposed. In this way, in the spacer formation layer 12, the region irradiated with the light is photo-cured.

Further, as shown in FIG. 4(d), the exposure of the spacer formation layer 12 is carried out in a state that the support base 11 is attached to the spacer formation layer 12, that is, using an exposure light passed through the support base 11.

Meanwhile, according to a conventional method, since a bonding surface of a spacer formation layer is kept exposed during the exposing step, it is easy to allow foreign substances such as dust to adhere to the surface or the spacer formation layer, when such foreign substances have once adhered to the surface of the spacer formation layer, it is difficult to remove the foreign substances therefrom. As a result, the foreign substances which have adhered prevent the exposure of the bonding film, which makes it difficult to form a spacer at sufficient dimensional accuracy.
Further, there is another problem in that a mask adheres to the bonding film during the exposing step. In order to present such adhesion of the mask to the spacer formation layer, it may be conceived to make a distance between the spacer formation layer and the mask longer. However, in the case where the distance between the spacer formation layer and the mask is made longer, an image formed from an exposure light with which the spacer formation layer is irradiated is likely to be dim. In such a case, a partition between an exposed region and a non-exposed region becomes unclear or unstable, which also makes it difficult to form the spacer at sufficient dimensional accuracy.

On the other hand, according to the present invention, since the exposure is carried out in the state that the support base is attached to the spacer formation layer, the support base can function as a protective layer of the spacer formation layers which makes it possible to prevent adhesion of foreign substances such as dust to the surface of the spacer formation layer effectively. Further, in the case where the foreign substances adhere to the support base, they can be easily removed.
Furthermore, even when the mask As placed, it is possible to prevent for the mask to adhere to the spacer formation layer, while making the distance between the mask and the spacer formation layer smaller. As a result, it is possible to present the image formed from the exposure light with which the spacer formation layer is irradiated from becoming dim. In this case, the border between the exposed region and the non-exposed region can become sharp (clear). As result, it is possible to form the spacer at sufficient dimensional accuracy, to thereby obtain each air-gap portion 105 surrounded by the spacer 104' so as to have a close designed shape. This makes it possible to obtain a semiconductor device having superior reliability.

The distance (spaced length) between the support base 11 and the mask 20 is preferable in the range of 0 (which is a state that the mask 20 makes contact with the support base 11) to 2,000 µm, and more preferably in the range of 0 to 1,000 µm. This makes it possible to more clearly form the image of the exposure light using the mask 20, to thereby form the spacer 104 at sufficient dimensional accuracy.

Especially, it is preferable to carry out the exposure an the state that the mask 20 makes contact with the support base 11. By doing so, since a distance between the spacer formation layer 12 and the mask 20 becomes equal to a thickness of the support base 11, it is possible to constantly maintain the distance between the spacer formation layer 12 and the mask 20. As a result, it is possible to uniformly expose a region of the spacer formation layer 12 to be exposed, to thereby form a spacer 104' having excellent dimensional accuracy, in a more reliable manner.

In the case where the exposure is carried out in such a case that the mask 20 makes contact with the support base 11, by appropriately selecting the thickness of The support base 11, it is possible to set the distance between the support base 11 and the mask 20 freely and reliably. This makes it possible to make the distance between the spacer formation layer 12 and the mask 20 smaller.

In consideration of the above matters, an average thickness of the support base 11 is, for example, preferably in the range of 15 to 50 µm, and more preferably in the range of 25 to 50 µm. If the average thickness of the support base 11 is less than the above lower limit value, there is a case that it is difficult to keep strength to be required as the support base. On the other hand, if the average thickness of the support base 11 exceeds the above upper limit value, in order that the spacer formation layer 12 is reliably irradiated with the exposure light, there is a case that energy of the light need set to a larger value, depending on a value of light transmission through the support base 11,

Further, in the present embodiment, as shown in FIG. 4(d), on the semiconductor wafer 101' and in the vicinity of an edge thereof, alignment marks 1011 are provided.

Furthermore, in the same way, as shown in FIG. 4(d), on the mask 20, alignment marks 202 for positioning are provided.

In the present exposing step, positioning of the mask 20 with respect to the semiconductor wafer 101' is carried out by aligning the alignment marks 1011 of the above semiconductor wafer 101' with the alignment marks 202 of the mask 20. This makes it possible to form the spacer 104' at high location accuracy, to thereby further improve reliability of the formed semiconductor device 100.

In this regard, it is to be noted that after the exposure, the spacer formation layer 12 may be subjected to a baking (heating) treatment at a temperature of about 40 to 80°C (this step is referred to as a post exposure baking step (PEB step)). By being subjected to such a baking treatment, it is passible to further improve adhesion between a region photo-cured during the exposing step (spacer 104') and the semiconductor wafer 101', to thereby effectively prevent undesired peeling-off of the photo-cured region during a developing step described below.

The temperature of the baking treatment only have to fall within the above range, but is preferably in the range of 50 to 70°C. This makes It possible to further effectively prevent the undesired peeling-off of the photo-cured region during the developing step described below.

Next, as shown in FIG. 4(e), the support base 11 is removed (this step is referred to as a support base removing step).
Next, as shown in FIG. 4(f), the spacer formation layer 12 is developed using an alkali aqueous solution. At this time, a non-cured region of the spacer formation layer 12 is removed so that the photo-cured region is remained as a spacer 104' having a grid-like shape (this step is referred to as a developing step). In other words, formed are regions 105' to be converted into the plurality of air-gap portions between the semiconductor wafer and the transparent substrate.

Next, as shown in FIG. 5(g), the transparent substrate 102' is bonded to an upper surface of the formed spacer 104' (this step is referred to as a bonding step). In this way, it is possible to obtain a semiconductor wafer bonding product 1000 (semiconductor wafer bonding product of the present invention) in which the semiconductor wafer 101', the spacer 104' and the transparent substrate 102' are laminated in this order.

The bonding of the transparent substrate 102' to the spacer 104' can be carried out, for example, by attaching the transparent substrate 102' to the upper surface of the formed spacer 104' and then being subjected to thermocompression bonding.

The thermocompression bonding is preferably carried out within a temperature range of 80 to 180°C. This makes it possible to form the spacer 104 so as to have a favorable shape.

Next, as shown in FIG. 5(h), ground is a lower surface (rear surface) 111 of the semiconductor wafer 101' opposite to the surface to which the transparent substrate 102' is bonded (this step is referred to as a back grinding step).

This lower surface 111 can be ground by, for example, a grinding plate provided in a grinding machine (grander).

By grinding such a lower surface 111, a thickness of the semiconductor wafer 101' is generally set to about 100 to 60°C µm depending on an electronic device in which the semiconductor device 100 is used. In the case where the semiconductor device 100 is used in an electronic device having a smaller size, the thickness of the semiconductor wafer 101' is set to about 50 µm.

Next, the lower surface (rear surface) 111 of the ground semiconductor wafer 101' is subjected to a processing (this step is referred to as a rear surface processing steep).

Examples of such a processing include, for example, formation of a circuit (wiring) onto the lower surface 111, connection of the solder bumps 106 thereto as shown in FIG. 5(i), and the like.

Next, the semiconductor wafer bonding product 1000 is diced so as to correspond to each individual circuit formed on the semiconductor wafer 101', that is, each air-gap portion 105 inside the spacer 104, to thereby obtain the plurality of semiconductor devices 100 (this step is referred to as a dicing step). In other words, by dicing the semiconductor wafer bonding product 1000 along a portion corresponding to the spacer 104' and then being separated, the plurality of semiconductor devices 100 are obtained.

For example, the dicing of the semiconductor wafer bonding product 1000 is carried out by, as shown in FIG. 5(j), forming grooves 21 from a side of the semiconductor wafer 101' using a dicing saw so as to correspond to a position where the spacer 104' is formed, and then also forming grooves from a side of the transparent substrate 102' using the dicing saw so as to correspond to the grooves 21.
Through the above steps, the semiconductor device 100 can be manufactured.

In this way, by dicing the semiconductor wafer bonding product 1000 to thereby obtain the plurality of semiconductor devices 100 at the same time, it is possible to mass-produce the semiconductor devices 100, and thus to improve productive efficiency thereof.

In this regard, for examples, by mounting the semiconductor device 100 on a support substrate provided with a circuit (patterned wiring) via the solder bumps 106, the circuit formed on the support substrate is electrically connected to the circuit formed on the lower surface of the base substrate 101 via the solder bumps 106.

Further, the semiconductor device 100 mounted on the support substrate is widely used in electronics such as a cellular telephone, a digital camera, a video camera and a miniature camera.

In this regard, in the description of the present embodiment, the PEB step is carried out by exposing the spacer formation layer 12 and then baking it, but be omitted depending on the kind of a resin composition constituting the spacer formation layer 12.

Further, the above description is made on the case that the spacer formation layer 12, which has been formed on the semiconductor wafer 101', is exposed and developed, and then the transparent substrate 102' is bonded to the spacer 104'. However, the present invention is not limited to such a case, but may be carried out by exposing and developing the spacer formation layer 12 which has been formed on the transparent substrate 102', and then bonding the semiconductor wafer 101' to the spacer 104'.
In such a case, it is preferred that an alignment marks have been, in advance, formed on the transparent substrate 102', and when the mask 20 is placed so as to face the support base 11 in the exposing, step, the positioning of the mask 20 is carried out by aligning alignment marks provided on the transparent substrate 102' with alignment marks 202 provided on the mask 20. This makes it possible to form the spacer 104' at high location accuracy, to thereby further improve reliability of the formed semiconductor device 100.

### <Resin composition constituting spacer formation layer 12>

Next, description will be made on a preferred embodiment of the resin composition constituting the spacer formation layer 12.

The spacer formation layer 12 is a layer having a photo curable property, an alkali developable property and a thermosetting property, and is formed of a material (resin composition) containing an alkali soluble resin, a thermosetting resin and a photo polymerization initiator.

hereinbelow, description will be made on each component of the resin composition in detail.

### (Alkali soluble resin)

Tne resin composition constituting the spacer formation layer 12 contains the alkali soluble resin. This makes it possible to have the alkali developable property to the spacer formation layer 12.

Examples of the alkali soluble resin include: a novolac resin such as a cresol-type novolac resin, a phenol-type novolac resin, a bisphenol A-type novolac resin, a bisphenol F-type novolac resin, a catechol-type novolac resin, a resorcinol-type novolac resin and a pyrogallol-type novolac resin; a phenol aralkyl resin; a hydroxystyrene resin; an acryl-based resin such as a methacrylic acid resin and a methacrylic acid ester resin; a cyclic olefin-based resin containing hydroxyl groups, carboxyl groups and the like; a polyamide-based resin; and the like. These alkali soluble resins may be used singly or in combination of two or more of them.
In this regard, concrete examples of the polyamide-based resin include: a resin containing at least one of a polybenzoxazole structure and a polyimide structure, and hydroxyl groups, carboxyl groups, ether groups or ester groups in a main chain or branch chains thereof; a resin containing a polybenzoxazole precursor structure; a resin containing a polyimide precursor structure; a resin containing a polyamide acid ester structure; and the like.

Among these alkali soluble resins, it is preferable to use an alkali soluble resin containing both alkali soluble groups, which contribute to the alkali developing and double bonds.

Examples of the alkali soluble groups include a hydroxyl group, a carboxyl group and the like. The alkali soluble groups can contribute to a thermal curing reaction in addition to the alkali developing. Further, since the alkali soluble resin contains the double bonds, it also can contribute to a photo curing reaction.

Examples of such a resin containing alkali soluble groups and double bonds include a curable resin which can be cured by both heat and light. Concrete examples of the curable resin include a thermosetting resin containing photo reaction groups such as an acryloyl group, a methacryloyl group and a vinyl group; a photo curable resin containing thermal reaction groups such as a phenolic hydroxyl group, an alcoholic hydroxyl group, a carboxyl group and an anhydride group; and the like.

In this regard, it is to be noted that the photo curable resin containing thermal reaction groups may further have thermal reaction groups such as an epoxy group, an amino group and a cyanate group. Concrete examples of the photo curable resin having such a chemical structure include a (meth)acryl-modified phenol resin, an acryl acid polymer containing (meth)acryloyl groups, an (epoxy)acrylate containing carboxyl groups, and the like. Further, the photo curable resin may be a thermoplastic resin such as an acryl resin containing carboxyl groups.

Among the above resins each containing alkali soluble groups and double bonds (curable resins which can be cured by both heat and light), it is preferable to use the (meth)acryl-modifled phenol resin.
By using the (meth)acryl-modified phenol resin, since the resin contains the alkali soluble groups, when the resin which has not reacted is removed during a developing treatment, an alkali solution having less adverse effect on environment can be used as a developer instead of an organic solvent which is normally used. Further, since the resin contains the double bonds, these double bonds contribute to the curing reaction. As a result, it is possible to improve heat resistance of the resin composition.
Further, by using the (meth)acryl-modified phenol resin, it is possible to reliably reduce a degree of warp of the semiconductor wafer bonding product 1000. From the viewpoint of such a fact, it is also preferable to use the (meth)acryl-modified phenol resin.

Examples of the (meth)acryl-modified phenol resin include a (meth)acryloyl-modified bisphenol resin obtained by reacting hydroxyl groups contained in bisphenols with epoxy groups of compounds containing epoxy groups and (meth)acryloyl groups.

Concretely, examples of such a (Meth)acryloyl-modified bisphenol resin include a resin represented by the following chemical formula 1.

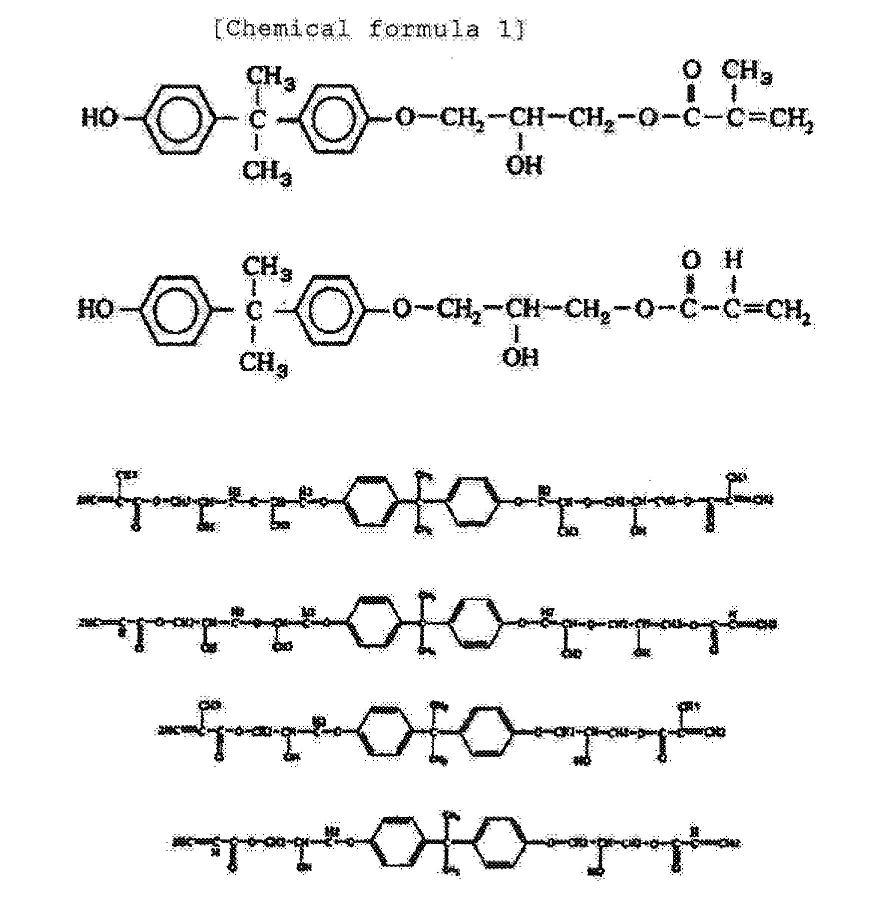

Further, as another (meth)acryloyl-modified bisphenol resin, exemplified is a compound introducing a dibasic acid into a molecular chain of a (meth)acryloyl-modified epoxy resin in which (meth) acryloyl groups are bonded to both ends of an epoxy resin, the compound obtained by bonding one of carboxyl groups or the dibasic acid to one hydroxyl group of the molecular chain of the (meth)acryloyl-modified epoxy resin via an ester bond. In this regard, it is to be noted that this compound has one or more repeating units of the epoxy resin and one or more dibasic acids introduced into the molecular chain.
Such a compound can be synthesized by reacting epoxy groups existing both ends of an epoxy resin obtained by polymerizing epichlorohydrin and polyalcohol with (meth)acrylic acid to obtain a (meth)acryloyl-modified epoxy resin in which acryloyl groups are introduced into both the ends of the epoxy resin, and then reacting hydroxyl groups of a molecular chain of the (meth)acryloyl-modified epoxy resin with an anhydride of a dibasic acid to form an ester bond together with one of carboxyl groups of the dibasic acid.

Here, in the case of using the thermosetting resin containing photo reaction groups, a modified ratio (substitutional ratio) of the photo reaction groups is not limited to a specific value, but is preferably in the range of about 20 to 80%, and more preferably about 30 to 70% with respect to total reaction groups of the resin containing alkali soluble groups and double bonds. If the modified ratio of the photo reaction groups falls within the above range, it is possible to provide a resin composition having an excellent developing property.

On the other hand, in the case of using the photo curable resin containing thermal reaction groups, a modified ratio (substitutional ratio) of the thermal reaction groups is not limited to a specific value, but is preferably in the range of about 20 to 80%, and more preferably in the range of about 30 to 70% with respect to total reaction groups of the resin containing alkali soluble groups and double bonds. If the modified ratio of the thermal reaction groups falls within the above range, it is possible to provide a resin composition having an excellent developing property.

Further, in the case where the resin having alkali soluble groups and double bonds is used as the alkali soluble resin, a weight-average molecular weight of the resin is not limited to a specific value, but is preferably 30,000 or less, and more preferably in the range of about 5,000 to 15,000. If the weight-average molecular weight falls within the above range, it is possible to further improve a film forming property of the resin composition in forming the spacer formation layer onto a film (support base).

Here, the weight-average molecular weight of the alkali soluble rein can be measured using, for example, a gel permeation chromatographic method (GPC). That is, according to such a method, the weight-average molecular weight can be calculated based on a calibration curve which has been, in advance, made using styrene standard substances. In this regard, it is to be noted that the measurement is carried out using tetrahydrofuran (THF) as a measurement solvent at a measurement temperature of 40°C.

Further, an amount of the alkali soluble resin contained in the resin composition is not limited to a specific value, but is preferably in the range of about 15 to 50 wt%, and more preferably in the range of about 20 to 40 wt% with respect to a total amount of the resin composition. In this regard, in the case where the resin composition contains a filler described below, the amount of the alkali soluble resin may be preferably in the range of about 10 to 80 wt%, and more preferably in the range of about 15 to 70 wt% with respect to resin components contained in the resin composition (total components excluding the filler).
If the amount of the alkali soluble resin is less than the above lower limit value, there is a fear that an effect of improving compatibility with other components (e.g., a photo curable resin and thermosetting resin described below) contained in the resin composition is lowered. On the other hand, if the amount of the alkali soluble resin exceeds the upper limit value, there is a fear that the developing property of the resin composition or patterning resolution of the spacer formed by a photo lithography technique is lowered. In other words, by allowing the amount of the alkali soluble resin to fall within the above range, the resin composition can more reliably exhibit a property suitable for the thermocompression bonding after being patterned by the photo lithography technique.

### (Thermosetting resin)

Further, the resin composition constituting the spacer formation layer 12 also contains the thermosetting resin. This makes it possible for the spacer formation layer 12 to exhibit a bonding property due to curing thereof, even after being exposed and developed. Namely, the transparent substrate 10 can be bonded to the spacer formation layer 12 by the thermocompression bonding, after the spacer formation layer 12 has been bonded to the semiconductor wafer, and exposed and developed.

In this regard, in the case where the curable resin which can be cured by neat is used as the above alkali soluble resin, a resin other than the curable resin is selected as the thermosetting resin.

Concretely, examples of the thermosetting resin include: a novolac-type phenol resin such as a phenol novolac resin, a cresol novolac resin and a bisphenol A novolac resin; a phenol resin such as a resol phenol resin; a bisphenol-type epoxy resin such as a bisphenol A epoxy resin and a bisphenol F epoxy resin; a novlolac-type epoxy resin such as a novolac epoxy resin and a cresol novolac epoxy resin; an epoxy resin such as a biphenyl-type epoxy resin, a stilbene-type epoxy resin, a triphenol methane-type epoxy resin, an alkyl-modified triphenol methane-type epoxy resin, a triazine chemical structure-containing epoxy resin and a dicyclopentadiene-modified phenol-type epoxy resin; an urea resin; a resin having triazine rings such as a melamine resin; an unsaturated polyester resin; a bismaleimide resin; a polyurethane resin; a diallyl phthalate rosin; a silicone resin; a resin having benzooxazine rings; a cyanate ester resin; an epoxy-modified-siloxane; and the like. These thermosetting resins may be used singly or in combination of two or more of them.
Among them, it is preferable to use the epoxy resin. This makes it possible to improve heat resistance of the resin composition and adhesion of the transparent substrate 1 thereto.

Further, in the case of using the epoxy resin, it is preferred that both an epoxy resin in a solid form at room temperature (in particular, bisphenol-type epoxy resin) and an epoxy resin, in a liquid form at room temperature (in particular, silicone-modified epoxy resin in a liquid form at room temperature) are used together as the epoxy resin. This makes it possible to obtain a spacer formation layer 12 having excellent flexibility and resolution, while maintaining heat resistance thereof.

An amount of the thermosetting resin contained in the resin composition is not limited to a specific value, but preferably in the range of about 10 to 40 wt%, and more preferably in the range of about 15 to 35 wt% with respect to the total amount of the resin composition. If the amount of the thermosetting resin is less than the above lower limit value, there is a case that an effect of improving the heat resistance of the spacer formation layer 12 to be obtained is lowered. On the other hand, if the amount of the thermosetting resin exceeds the above upper limit value, there is a case that an effect of improving toughness of the spacer formation layer 12 is lowered.

Further, in the case of using the above epoxy resin, it is preferred that the thermosetting resin further contains the phenol novolac resin in addition to the epoxy resin. Addition of the phenol novolac resin makes it possible to improve the resolution of the spacer formation layer 12. Furthermore, in the case where the resin composition contains both the epoxy resin and the phenol novolac resin as the thermosetting resin, it is also possible to obtain an advantage that the thermosetting property of the epoxy resin can be further improved, to thereby make the strength of the spacer 104 hither.

### (Photo polymerization initiator)

The resin composition constituting the spacer formation layer 12 also contains the photo polymerization initiator. This makes it possible to effectively pattern the spacer formation layer 12 through photo polymerization.

Examples of the photo polymerization initiator include benzophenone, acetophenone, benzoin, benzoin isobutyl ether, benzoin methyl benzoate, benzoin benzoic acid, benzoin methyl ether, benzyl phenyl sulfide, benzyl, dibenzyl, diacetyl, dibenzyl dimethyl ketal and the like.

An amount of the photo polymerization initiator contained in the resin composition is not limited to a specific value, but is preferably in the range of about 0.5 to 5 wt% and more preferably in the range of about 0.8 to 3.0 wt% with respect to the total amount of the resin composition. It the amount of the photo polymerization initiator is less than the above lower limit value, there is a fear that an effect of starting the photo polymerization is lowered. On the other hand, if the amount of the photo polymerization initiator exceeds the above upper limit value, reactivity of the resin composition is extremely improved, and therefore there is a fear that storage stability or resolution thereof is lowered.

### (Photo polymerizable resin)

It is preferred that the resin composition constituting the spacer formation layer 12 also contains a photo polymerizable resin in addition to the above components. In this case, since the photo polymerizable resin is contained in the resin composition together with the above alkali soluble resin, it is possible to further improve a patterning property of the spacer formation layer 12 to be obtained.

In this regard, in the case where the curable resin which can be cured by light is used as the above alkali soluble resin, a resin other than the curable resin is selected as the photo polymerizable resin,

Examples of the photo polymerizable resin include: but are not limited to, an unsaturated polyester; an acryl-based compound such as an acryl-based monomer and an acryl-based oligomer each containing one or more acryloyl groups or one or more methacryloyl groups in a chemical structure thereof; a vinyl-based compound such as styrene; and the like. These photo polymerizable resins may be used singly or in combination of two or more of them.

Among them, an ultraviolet curable resin containing the acryl-based compound as a major component thereof is preferable. This is because a curing rate of the acryl-based compound is fast when being exposed with light, and therefore it is possible to appropriately pattern the resin with a relative small exposure amount,

Examples of the acryl-based compound include a monomer of an acrylic acid ester or methacrylic acid ester, and the like. Concretely, examples of the monomer include: a difunctional (meth)acrylate such as ethylene glycol di(meth)acrylate, 1,6-hexanediol di(meth)acrylate, glycerin di(meth)acrylate and 1,10-decanediol di(meth)acrylate; a trifunctional (meth)acrylate such as trimethylol propane tri(meth)acrylate and pentaerythritol tri(meth)acrylate; a tetrafunctional (meth)acrylate such as pentaerythritol tetra(meth)acrylate and ditrimethylol propane tetra(meth)acrylate; a hexafunctional (meth)acrylate such as dipentaerythritol hexa(meth)acrylate; and the like.

Among these acryl-based compounds, it is preferable to use an acryl-based polyfunctional monomer. This makes it possible for the spacer 104 to be obtained from The spacer formation layer 12 to exhibit excellent strength. As a result, a semiconductor device 100 provided with the spacer 104 can have a more superior shape keeping property.

In this regard it is to be noted that, in the present specification, the acryl-based polyfunctional monomer means a monomer of a (meth)acrylic acid ester containing three or more acryloyl groups or (meth)acryloyl groups.

Further, among the acryl-based polyfunctional monomers, it is more preferable to use the trifunctional (meth)acrylate or the tetrafunctional (meth)acrylate. This makes it possible to exhibit the above effects more remarkably.

In this regard, in the case of using the acryl-based polyfunctional monomer, it is preferred that the photo polymerizable resin further contains an epoxy vinyl ester resin. In this case, since the acryl-based polyfunctional monomer is reacted with the epoxy vinyl ester resin by radical polymerization when exposing the spacer formation layer 12, it is possible to more effectively improve the strength of the spacer 104 to be formed. On the other hand, it is possible to improve solubility of the non-exposed region of the spacer formation layer 12 with the alkali developer when developing it, to thereby reduce residues after the development.

Examples of the epoxy vinyl ester resin include 2-hydroxyl-3-phenoxypropyl acrylate, EPOLIGHT 40E methacryl addition product, EPOLIGHT 70P acrylic acid addition product, EPOLIGHT 200P acrylic acid addition product, EPOLIGHT 80MF acrylic acid addition product, EPOLIGHT 3002 methacrylic acid addition product, EPOLIGHT 3002 acrylic acid addition product, EPOLIGHT 1600 acrylic acid addition product, bisphenol A diglycidyl ether methacrylic acid addition product, bisphenol A diglycidyl ether acrylic acid addition products, EPOLIGHT 200E acrylic acid addition product, EPOLIGHT 400E acrylic acid addition product, and the like.

In the case where the photo polymerizable resin contains the acryl-based polyfunctional monomer, an amount of the acryl-based polyfunctional monomer contained in the resin composition is not limited to a specific value, but is preferably in the range of about 1 to 50 wt%, and more preferably in the range of about 5 to 25 wt% with respect to the total amount of the resin composition. This makes it possible to more effectively improve the strength of the spacer formation layer 12 after being exposed, that is, the spacer 104, and thus to more effectively improve the shape keeping property thereof when the transparent substrate 102 is bonded to the semiconductor wafer 101'.

Further, in the case where the photo polymerizable resin contains the epoxy vinyl ester resin in addition to the acryl-based polyfunctional monomer, an amount of the epoxy vinyl ester resin is not limited to a specific value, but is preferably in the range of about 3 to 30 wt%, and more preferably in the range of about 5 to 15 wt% with respect to the total amount of the resin composition. This makes it possible to more effectively reduce a residual ratio of residues attached to each surface of the semiconductor wafer and transparent substrate after the transparent substrate is bonded to the semiconductor wafer.

Further, it is preferred that the above photo polymerizable resin is in a liquid form at room temperature. This makes it possible to further improve curing reactivity of the photo polymerizable resign by light irradiation (e.g., by ultraviolet ray irradiation). Further, it is possible to easily mix the photo polymerizable resin with the other components (e.g. alkali soluble resin). Examples of the photo polymerizable resin in the liquid form at the room temperature include the above ultraviolet curable resin containing the acryl-based compound as the major component thereof, and the like.

In this regard, it is to be noted that a weight-average molecular weight of the photo polymerizable resin is not limited to a specific value, but is preferably 5,000 or less, and more preferably in the range of abort 150 to 3,000. If the weight-average molecular weight falls within the above range, sensitivity of the spacer formation layer 12 becomes specifically higher. Further, the spacer formation layer 12 can also have superior resolution.

Here, the weight-average molecular weight of the photo polymerizable resin can be measured using the gel permeation chromatographic method (GPC), and is calculated in the same manner as described above.

### (Inorganic filler)

In this regard, it is to be noted that the resin composition constituting the spacer formation layer 12 may also contain an inorganic filler. This makes it possible to further improve the strength of the spacer 104 to be formed from the spacer formation layer 12.

However, in the case where an amount of the inorganic filler contained in the resin composition becomes too large, raised are problems such as adhesion of foreign substances derived from the inorganic filler onto the semiconductor wafer 101' and occurrence of undercut after developing the spacer formation layer 12. For this reason, it is preferred that the amount of the inorganic filler contained in the resin composition is 9 wt% or less with respect to the total amount of the resin composition.

Further, in the case where the resin composition contains the acryl-based polyfunctional monomer as the photo polymerizable resin, since it is possible to sufficiently improve the strength of the spacer 104 to be formed from the spacer formation layer 12 due to the addition of the acryl-based polyfunctional monomer, the addition of the inorganic filler to the resin composition can be omitted.

Examples of the inorganic filler include: a fibrous filler such as an alumina fiber and a glass fiber; a needle filler such as potassium titanate, wollastonite, aluminum borate, needle magnesium hydroxide and whisker; a platy filler such as talc, mica, sericite, a glass flake, scaly graphite and platy calcium carbonate; a globular (granular) filler such as calcium carbonate, silica, fused silica, baked clay and non-baked clay; a porous filler such as zeolite and silica gel; and the like. These inorganic fillers may be used singly or in combination of two or more of them. Among them, it is preferable to use the porous filler.

An average particle size of the inorganic filler is not limited to a specific value, but is preferably in the range of about 0.01 to 90 µm, and more preferably in the range of about 0.1 to 40 µm. If the average particle size exceeds the upper limit value, there is a fear that appearance and resolution of the spacer formation layer 12 are lowered. On the other hand, if the average particle size is less than the above lower limit value, there is a fear that the transparent substrate 102 cannot be reliably bonded to the spacer 104 even by the thermocompression bonding.

In this regard, it is to be noted that the average particle size is measured using, for example, a particle size distribution measurement apparatus of a laser diffraction type ("SALD-7000" produced by Shimadzu Corporation).

Further, in the case where the porous filler is used as the inorganic filler, an average hole size of the porous filler is preferably in the range of about 0.1 to 5 nm, and more preferably in the range of about 0.3 to 1 nm.

The resin composition constituting the spacer formation layer 12 can also contain an additive agent such as a plastic resin, a leveling agent, a defoaming agent or a coupling agent in addition to the above components insofar as the purpose of the present invention is not spoiled.

By constituting the spacer formation layer 12 from the resin composition as described above, it is possible to more appropriately adjust the visible light transmission through the spacer formation layer 12, to thereby more effectively prevent the exposure from becoming insufficiency during the exposing step. As a result, it is possible to provide a semiconductor device having higher reliability.

while the present invention has been described hereinabove with reference to the preferred embodiment, the present invention is not limited thereto.

For example, in the manufacturing method of the present invention, one or more steps may be added for arbitrary purposes. For examples, between the laminating step and the exposing step, a post laminate baking step (PLB steep), in which the spacer formation layer is subjected to a baking (heating) treatment, may be provided.

Further, in the description of the above embodiment, the exposure is carried out just once, but may be, for example, more than once.

### EXAMPLES

Hereinafter, description will be made on the present invention based on the following Examples and Comparative Example, but the present invention is not limited thereto.

### [1] Manufacture of semiconductor wafer bonding product

In each of Examples and Comparative Example, 100 semiconductor wafer bonding products were manufactured as follows, respectively.

### (Example 1)

### 1. Synthesis of alkali soluble resin (methacryloyl-modified novolac-type bisphenol A resin)

500 g of a MEK (methyl ethyl ketone) solution containing a novolac-type bisphenol A resin ("Phenolite LF-4871" produced by DIC corporation) with a solid content of 60% was added into a 2L flask. Thereafter, 1.5 q of tributylamine as a catalyst and 0.15 g of hydroquinone as a polymerization inhibitor were added into the flask, and then they were heated at a temperature of 100°C. Next, 180.9 g of glycidyl methacrylate was further added into the flask in drop by drop for 30 minutes, and then they were reacted with each other by being stirred for 5 hours at 100°C, to thereby obtain a methacryloyl-moditied novolac-type bisphenol A resin "MPN001" (methacryloyl modified ratio: 50%) with a solid content of 74%.

### 2. Preparation of resin varnish containing resin composition constituting spacer formation layer

15 wt% of trimethylol propane trimethacrylate ("LIGHT-ESTER TMP" produced by KYOEISHA CHEMICAL Co., LTD.) and 5 wt% of an epoxy vinyl ester resin ("EPOXYESTER 3002M" produced by KYOEISAA CHEMICAL Co., LTD) as a photo polymerizable resin; 5 wt% of bisphenol A novolac-type epoxy resin ("Epiclon N-865" produced by DIC Corporation, 10 wt% of a bisphenol A-type epoxy resin ("YL 6810" produced by Japan Epoxy Resins Co., Ltd), 5 wt% of a silicone epoxy resin ("BY 16-115" produced by Dow Cornng Toray Co., Ltd) and 3 wt% of a phenol novolac resin ("PR 53647" produced by Sumitomo Bakelite Co., Ltd.) as an epoxy resin which was a thermosetting resin; 55 wt%) of the above MPN001 (solid content) as an alkali soluble resin; and 2 wt% of a photo polymerization initiator ("IRGACURE 651" produced by Ciba Specialty Chemicals) were weighed, and stirred at a rotation speed of 3,000 rpm for 1 hour using a disperse, to prepare a resin varnish.

### 3. Production of spacer formation film

First, prepared was a polyester film ("MRX 50" produced by Mitsubishi Plastics, Inc.) as a support base. The polyester film had a thickness of 50 µm, visible light (600 nm) transmission of 85% and exposure light (i-beam (365 nm)) transmission of 76%.

Next, the above prepared resin varnish was applied onto the support base using a konma coater "model number: MGF No. 194001 type 3-293" produced by YASUI SEIKI) to form a coating film constituted from the resin varnish. Thereafter, the coating film was dried at 80°C for 20 minutes to form a spacer formation layer. In this way, the spacer formation film was obtained. In the obtained spacer formation film, an average thickness of the spacer formation layer was 50 µm and visible light (600 nm) transmission therethrough was 99%.

### 4. Manufacture of bonding product

First, prepared was a semiconductor wafer having a substantially circular shape and a diameter of 8 inches (Si wafer, diameter of 20.3 cm and thickness of 725 µm). In this regard, it is to be noted that 2 alignment marks were formed on the semiconductor wafer so as to be symmetrical, with respect to a point corresponding to a central axis of the semiconductor wafer at a position of 5 mm from the edge of the semiconductor wafer.

Next, the above produced spacer formation film was laminated on the semiconductor wafer using a roll laminate under the conditions in which a roll temperature was 60°C, a roll speed was 0.3 m/min and a syringe pressure of 2.0 kgf/cm², to thereby obtain the semiconductor wafer with the spacer formation film.

Next, prepared was a mask provided with 2 alignment marks for positioning with respect to the semiconductor wafer and a light passing portion having the same shape as a planar shape of a spacer to be formed. Thereafter, The mask was placed so as to face the spacer formation film, while aligning the alignment marks of the mask with the alignment marks of the semiconductor wafer. At this time, a distance between the mask and the support base was set to 0 mm.

Next, the semiconductor wafer with the spacer formation film was irradiated with an ultraviolet ray (wavelength of 365 nm and accumulated light intensity of 700 mJ/cm²) from a side of the spacer formation film so that the spacer formation layer was exposed in grid-like fashion, and then the support base was removed therefrom. In this regard, it is to be noted that when exposing the spacer formation layer, a width of a region to be exposed in grid-like fashion was set to 0.6 mm so as to expose 50% of the spacer formation layer at a planar view thereof.

Next, the exposed spacer formation layer was developed using 2.38 wt% of tetramethyl ammonium hydroxide (TMAH) aqueous solution as a developer (alkali solution) under the conditions in which a developer pressure was 0.2 MPa and a developing time was 90 seconds. In this way, formed was a spacer composed of ribs each having a width of 0.6 mm onto the semiconductor wafer.

Next, prepared was a transparent substrate (quartz glass substrate, diameter of 20.3 mm and thickness of 725 µm). This transparent substrate was bonded to the semiconductor wafer, on which the spacer had been formed, by compression bonding using a substrate bonder ("SB8e" produced by Suss Microtec k.k.). In this way, manufactured was a semiconductor wafer bonding product in which the transparent substrate was bonded to the semiconductor wafer through the spacer.

### (Examples 2 and 3)

Each of semiconductor wafer bonding products was manufactured in the same manner as Example 1, except that the compounding ratio of the components contained in the resin composition constituting the spacer formation layer was changed as shown in Table 1.

### (Examples 4 to 10)

Each of semiconductor wafer bonding products was manufactured in the same manner as Example 1, except that the average thickness of the support base and the distance between the mask and the support base were changed as shown in Table 1.

### (Comparative Example)

Each of semiconductor wafer bonding products was manufactured in the same manner as Example 1, except that in the exposing step, the support base was removed from the spacer formation film, a distance between the spacer formation layer and the mask was set to 3,000 µm, and then the spacer formation layer was exposed.

In each of Examples and Comparative Example, the kind, amount and the like of each component containing the resin composition constituting the spacer formation layer are shown in Table 1,
In Table 1, indicated are the methacryloyl-modified novolac-type bisphenol A resin as "MPN", the trimethylol propane trimethacrylate as "TMP", the epoxy vinyl ester resin as "3002M", the bisphenol A novolac-type epoxy resin as "N865", the bisphenol A-type epoxy resin as "YL", the silicone epoxy resin as "BY16" and the phenol novolac resin as "PR", respectively.

[Table 1]

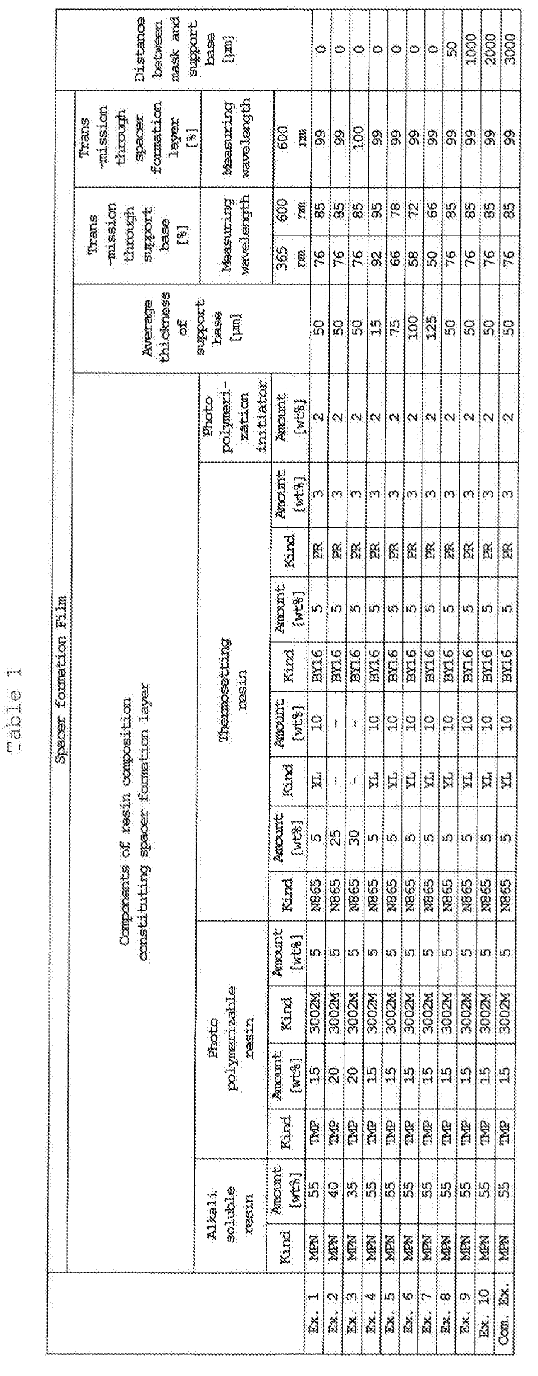

### [2] Evaluation of patterning property by exposure

### [2-1] Evaluation 1

An actual size of the spacer of the semiconductor wafer bonding product manufactured in each of Examples and Comparative Example was measured using a stereoscopic microscope (500 folds), the measured value was compared with a target size, and then a patterning property by exposure was evaluated based on the following evaluation criteria.
A; Dimensional accuracy is 99% or more.
B: Dimensional accuracy is 96% or more, but less than 99%.
C: Dimensional accuracy is 93% or more, but less than 96%.
D: Dimensional accuracy is less than 93%.

### [2-2] Evaluation 2

Shapes of the spacers of the 100 semiconductor wafer bonding products manufactured in each of Examples and Comparative Example were observed using a stereoscopic microscope (5,000 folds), and then a patterning property by exposure was evaluated based on the following evaluation criteria.
A: All the 100 spacers have no chips or the like, and have been patterned at high patterning accuracy.
B: Among the 100 spacers, 1 to 10 spacers have chips or the like, but have been patterned at such patterning accuracy so as to not be practically a problem.
C: Among the 100 spacers, 11 to 20 spacers have chips or the like, and have not been patterned at sufficient patterning accuracy.
D: Among the 100 spacers, 21 or more spacers have chips or the like, and have been patterned at low patterning accuracy.

### [3] Evaluation of developing property

The spacer and air-gap portion of an arbitrary one of the semiconductor wafer bonding products manufactured in each of Examples and Comparative Example were observed using a stereoscopic microscope (500 folds), and then existence or nonexistence of residues was evaluated based on the following evaluation criteria.
A: No residues are observed at all, and thus the semiconductor wafer bonding product is not practically a problem.
B: A few residues are observed, but the semiconductor wafer bonding product has a level that is not practically a problem.
C: Relatively many residues are observed, and thus the semiconductor wafer does not have a practical level.
D: Many residues are observed, and thus the semiconductor wafer does not have a practical level.
These results are shown in Table 2.

### [4] Manufacture of semiconductor device (light receiving device)

The semiconductor wafer bonding product manufactured in each of Examples and Comparative Example was diced along a portion corresponding to the spacer using a dicing saw, to thereby obtain a plurality of light receiving devices.

### (Reliability of light receiving device)

10 obtained light receiving devices were subjected to 1,000 cycles of a heat cycle test in which a treatment at -55°C for 1 hour and a treatment at 125°C for 1 hour were repeatedly performed, and then observation of cracks or peel-off was carried out and evaluated based on the following evaluation criteria.
A: No cracks and peel-off were observed in all the light receiving devices, and thus they are not practically a problem at all.
B: A few cracks and peel-off were observed in two or less light receiving devices, but they are not practically a problem.
C: Cracks and peel-off were observed in three or more light receiving devices, and thus they do not have a practical level.
D: Cracks and peel-off were observed in eight or more light receiving devices, and thus they do not have a practical level.
This result is also shown in Table 2 together with the above result.

[Table 2]

**Table 2**

| | Patterning property | | Developing property | Reliability of semiconductor device |
|---|---|---|---|---|
| | Evaluation 1 | Evaluation 2 | | |
| Ex. 1 | A | A | A | A |
| Ex. 2 | A | A | B | A |
| Ex. 3 | A | A | B | A |
| Ex. 4 | A | A | A | A |
| Ex. 5 | A | A | A | A |
| Ex. 6 | A | A | A | A |
| Ex. 7 | B | B | A | B |
| Ex. 8 | A | A | A | A |
| Ex. 9 | A | A | A | A |
| Ex. 10 | B | B | A | B |
| Com. Ex. | D | D | B | C |

As shown in Table 2, in each of the semiconductor wafer bonding products according to the present invention, the spacer does not have cracks and has excellent dimensional accuracy. Further, each of the semiconductor devices manufactured using the semiconductor wafer bonding products according to the present invention has especially higher reliability.
On the other hand, in Comparative Example, the patterning accuracy by the exposure is not sufficiently.

### INDUSTRIAL APPLICABILITY

According to the present invention, it is possible to provide a semiconductor device having excellent reliability, and a semiconductor wafer bonding product and method thereof each capable of easily manufacturing such a semiconductor device. Accordingly, the present invention has industrial applicability.

## Claims

1. A method of manufacturing a semiconductor wafer bonding product including a semiconductor wafer, a transparent substrate provided at a side of a functional surface of the semiconductor wafer and a spacer provided between the semiconductor wafer and the transparent substate, the method comprising:
a step of preparing a spacer formation film, the spacer formation film including a support base having a sheet-like shape and a spacer formation layer provided on the support base and having a bonding property;
a step of attaching the spacer formation layer of the spacer formation film to the functional surface of the semiconductor wafer;
a step of selectively exposing a region of the spacer formation layer to be formed into the spacer with an exposure light via a mask, which is placed at a side of the support base of the spacer formation film, so as to be passed through the support base;
a step of removing the support base after the exposure;
a step of developing the exposed spacer formation layer to form the spacer on the semiconductor wafer; and
a step of bonding the transparent substrate to a surface of the spacer opposite to the semiconductor water.

2. A method of manufacturing a semiconductor wafer bonding product including a semiconductor wafer, a transparent substrate provided at a side of a functional surface of the semiconductor wafer and a spacer provided between the semiconductor wafer and the transparent substrate, the method comprising:
a step of preparing a spacer formation film, the spacer formation film including a support base having a sheet-like shape and a spacer formation layer provided on the support base and having a bonding property;
a step of attaching the spacer formation layer of the spacer formation film to the transparent substrate;
a step of selectively exposing a region of the spacer formation layer to be formed into the spacer with an exposure light via a mask, which is placed at a side of the support base of the spacer formation film, so as to be passed through the support base;
a step of removing the support base after the exposure;
a step of developing the exposed spacer formation layer to form the spacer on the transparent substrate; and
a step of bonding the functional surface of the semiconductor wafer to a surface of the spacer opposite to the transparent substrate.

3. The method as claimed in claim 1, wherein in the step of exposing, when the mask is placed so as to face the support base, positioning of the mask is carried out by aligning alignment marks provided on the semiconductor wafer with alignment marks provided on the mask.

4. The method as claimed in claim 2, wherein in the step of exposing, when the mask is placed so as to face the support base, positioning of the mask is carried out by aligning alignment marks provided on the transparent substrate with alignment marks provided on the mask.

5. The method as claimed in claim 1 or 2, wherein visible light transmission through the transparent substrate is in the range of 30 to 100%.

6. The method as claimed in claim 1 or 2, wherein visible light transmission through the spacer formation layer is in the range of 3C to 100%.

7. The method as claimed in claim 1 or 2, wherein in the step of exposing, exposure light transmission through the support base is in the range of 50 to 100%.

8. The method as claimed in claim 1 or 2, wherein an average thickness of the support base is in the range of 15 to 50 µm.

9. The method as claimed in claim 1 or 2, wherein in the step of exposing, a distance between the mask and the support base is in the range of 0 to 1,000 µm.

10. The method as claimed in claim 1 or 2, wherein the spacer formation layer is formed of a material containing an alkali soluble resin, a thermosetting resin and a photo polymerization initiator.

11. The method as claimed in claim 10, wherein the alkali soluble resin is a (meth) acryl-modified phenol resin.

12. The method as claimed in claim 10, wherein the thermosetting resin is an epoxy resin.

13. A semiconductor wafer bonding product manufactured using the method defined by claim 1 or 2.

14. A semiconductor device obtained by dicing the semiconductor wafer bonding product defined by claim 13 along a portion corresponding to the spacer to obtain a plurality of chips of semiconductor devices.
